# EUROPEAN PATENT SPECIFICATION

(11) **EP 4 360 145 B1**
(45) Date of publication and mention of the grant of the patent: **08.10.2025**
(21) Application number: 22735936.1
(22) Date of filing: 17.06.2022
(51) Int. Cl.: G01T 1/29, H10F 30/29

(54) **A RADIATION DETECTOR**
STRAHLUNGSDETEKTOR
DÉTECTEUR DE RAYONNEMENT

(30) Priority: 22.06.2021 FI 20215731
(43) Date of publication of application: 01.05.2024
(73) Proprietor: Oxford Instruments Technologies Oy, 02150 Espoo (FI)
(72) Inventor: ANDERSSON, Hans, 01630 Vantaa (FI)
(74) Representative: Berggren Oy
(86) International application number: PCT/FI2022/050427
(87) International publication number: WO 2022/269129

(56) References cited:
- CN-A- 111 668 320
- CN-B- 109 671 798
- AUROLA A ET AL: "A radiation detector design mitigating problems related to sawed edges", JOURNAL OF INSTRUMENTATION, INSTITUTE OF PHYSICS PUBLISHING, BRISTOL, GB, vol. 9, no. 12, 9 December 2014 (2014-12-09), XP020275320, ISSN: 1748-0221, [retrieved on 20141209], DOI: 10.1088/1748-0221/9/12/C12019
- CAI LU ET AL: "A new type of silicon drift detector with curved surface", INTERNATIONAL SYMPOSIUM ON PHOTOELECTRONIC DETECTION AND IMAGING 2011: SENSOR AND MICROMACHINED OPTICAL DEVICE TECHNOLOGIES, SPIE, 1000 20TH ST. BELLINGHAM WA 98225-6705 USA, vol. 8191, no. 1, 25 August 2011 (2011-08-25), pages 1 - 7, XP060021894, DOI: 10.1117/12.900684

## Description

### TECHNICAL FIELD

The present invention relates to semiconductor radiation detectors.

### BACKGROUND

A semiconductor radiation detector may be applied as a component for detecting radiation (ionizing radiation or non-ionizing radiation), such as gamma rays, X-rays, ultraviolet (UV) radiation, visible radiation or charged particle radiation, e.g. in an analyzer device, in a spectrometer or in an electron microscope. A semiconductor radiation detector typically serves to output an electrical output signal that is descriptive of the detected level of radiation. In the following, we refer to the electrical output signal from a semiconductor radiation detector as a measurement signal.

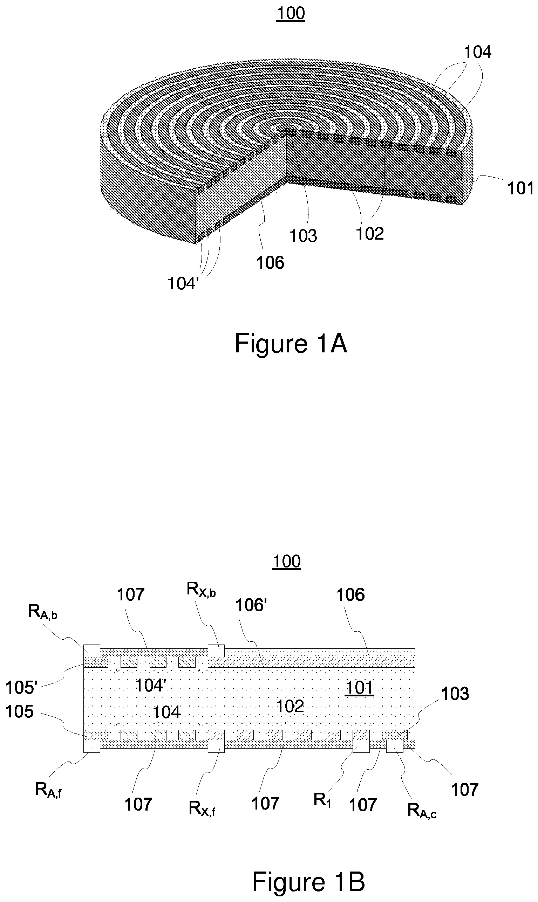

A non-limiting example of a radiation detector is a semiconductor drift detector (SDD). Figure 1A schematically illustrates a circular SDD 100 with a partial cutaway having a set of concentric annular field electrodes 102 arranged on a front surface of the block of semiconductor material 101 such that they encircle a collector electrode 103 arranged at or close to a common center point of the annular field electrodes 102 and hence at or close to the center of the front surface. The field electrodes 102 are further encircled by a set of annular guard electrodes 104. In this regard, it should be noted that the electrodes 102, 103, 104 arranged on the block of semiconductor material 101 constitute core elements of the SDD 100, while a real-life implementation includes a number of further elements, some of which will be described later in this text as part of the description of various embodiments of advantageous SDD structures described in the present disclosure. It should be likewise noted that the circular SDD design together with annular electrodes 102, 104 applied in the example of Figure 1A is a non-limiting example and a semiconductor block having a shape different from the circular one and/or electrodes 102, 104 having a shape different from the annular one may be applied instead.

In the SDD 100, the set of field electrodes 102 is arranged to create an electric field inside the semiconductor block 101, where the electric field drives signal charges (e.g. electrons) generated in the semiconductor block 101 due to incident radiation to the collector electrode 103. Typically, the SDD 100 is intended for receiving radiation through the radiation entrance window 106 arranged on the back surface of the semiconductor block 101, which is opposite surface to the front surface facing upwards in the schematic illustration of Figure 1A. The measurement signal that is descriptive of the level of radiation detected by the SDD 100 can be read out from the collector electrode 103. In order to create the electric field in the semiconductor block 101, each of the field electrodes 102 is set to a respective electric potential such that the magnitude of the electric potential (and hence a difference to the electric potential of the collector electrode 103) increases with increasing distance to the collector electrode 103.

In such an arrangement the collector electrode 103 is typically set at a ground potential (0 V) while the outermost one of the field electrodes 102 typically has a potential of a high magnitude, typically in a range of one hundred volts or even higher. Such a high potential close to an edge of the semiconductor block 101 runs a risk of an undesired leakage current, which would result in compromised detection performance. Therefore, the guard electrodes 104 are set to respective electric potentials such that the magnitude of the electric potential decreases towards the edge of the semiconductor block 101, thereby spanning an electric field that serves to passivate the volume of the semiconductor block 101 close to its perimeter in order to reduce or even completely eliminate leakage currents therefrom. Consequently, the field electrodes 102 and the guard electrodes 104 divide the volume of semiconductor block 101 into two portions: an active (or depleted) volume comprising the portion of the semiconductor block 101 that spatially coincides with the field electrodes 102 and that is available for collecting the signal charges generated in the semiconductor material due to incident radiation and a passive (e.g. non-depleted, non-active or dead) volume comprising the portion of the semiconductor block 101 that spatially coincides with the guard electrodes 104 and that does not contribute to collection of the radiation-generated signal charges. Hence, the radiation entrance window 106 covers the area of the back surface of the semiconductor block 101 that spatially coincides with the active volume and, consequently, the active volume is sandwiched between the radiation entrance window 106 on the back surface of the semiconductor block 101 and the area covered by the field electrodes 102 and collector electrode 103 on the front surface of the semiconductor block 101.

The radiation entrance window 106 on the back surface of the semiconductor block 101 may be introduced via growing a thermal oxide layer (such as silicon dioxide SiO₂) on the semiconductor block 101, wherein the oxide layer serves a protection and processing mask layer during subsequent steps of manufacturing of the SDD 100 while it may further serve as a passivation layer in the course of operation of the SDD 100. The radiation entrance window 106 may be created via etching the oxide layer at desired locations into a desired thickness (which may be in the order of tens of nanometers) to provide sufficient transparency to incident radiation, thereby providing the radiation entrance window 106. In this regard, providing the oxide layer of desired thickness in a uniform manner over the area to be covered by the radiation entrance window 106 is a non-trivial procedure while shortcomings in this regard are likely to result in compromised detection performance.

In general, the SDD design involves a trade-off between its physical size, its capability to capture incident radiation directed thereto, and an acceptable extent of leakage currents generated on its edge areas: for any given active area size it is typically desirable to minimize the physical size of the SDD 100 in order to enable operating the SDD 100 as close as possible to a radiation source to be measured, whereas it is likewise desirable to have a radiation entrance window that facilitates capturing as much as possible of the incident radiation directed towards the SDD 100 in order to maximize the detection performance in view of the physical size of the SDD 100. Moreover, in the interest of good detection performance it is important to minimize or even eliminate the leakage currents that may arise on the edge areas of the SDD 100.

In related art, CN 111 668 320 A discloses a silicon drift detector and a processing method thereof. The silicon drift detector comprises an N-doped silicon substrate and passivation films arranged on two surfaces of the silicon substrate, wherein the passivation film comprises an intrinsic amorphous silicon thin film, an aluminum oxide thin film and a silicon oxide thin film which are deposited on the silicon substrate; the intrinsic amorphous silicon film can better shorten dangling bonds on the surface of the silicon substrate and reduce the surface state of the silicon substrate; the intrinsic amorphous silicon has a certain conductive performance; and the aluminum oxide film can further enhance the passivation performance of the surface of the silicon substrate. In addition, due to the structural characteristics of the aluminum oxide thin film, a large number of fixed negative charges exist in the detector, positive charges generated by the silicon oxide thin film on the outer side under irradiation of functional rays can be shielded, and the positive charges are prevented from changing an electric field on the surface of the detector. Besides, all film layers in the passivation film can be formed through deposition under the low-temperature condition, the silicon substrate does not need to be located in a high-temperature environment, and damage to the silicon substrate due to the fact that a high-temperature preparation process is adopted for manufacturing the passivation film can be avoided.

Further in related art, CN 109 671 798 B discloses a drifted detector and a production method thereof. The drifted detector comprises a first conductive semiconductor substrate, an intrinsic semiconductor layer, a second conductive semiconductor layer, a third conductive semiconductor layer, a metal electrode layer and an isolating layer, wherein the conductive types of the second conductive semiconductor layer and the first conductive semiconductor substrate are opposite, the conductive types of the third conductive semiconductor layer and the first conductive semiconductor substrate are the same, the second conductive semiconductor layer, the portion, located under the second conductive semiconductor layer, of the intrinsic semiconductor layer and the first conductive semiconductor substrate form a PN junction, and the PN junction forms a shifted electrode, a first protective ring, an incidence window and a second protective ring; the third conductive semiconductor layer, the portion, located under the third conductive semiconductor layer, of the intrinsic semiconductor layer and the first conductive semiconductor substrate form a high-low junction, and the high-low junction forms an anode, a first grounded electrode and a second grounded electrode. The shifted detector is large in size, low in noise and high in energy resolution, and has a simple production technology, so that large-batch production is feasible.

### SUMMARY

It is therefore an object of the present invention to provide a SDD that enables improved radiation detection performance in view of the physical size of the SDD.

According to an example embodiment, a semiconductor radiation detector is provided, the semiconductor radiation detector comprising: a semiconductor block of a first conductivity type and comprising majority charge carriers of a first polarity; an electrode arrangement embedded on one or more surfaces of the semiconductor block, the electrode arrangement comprising at least one collector electrode embedded on a front surface of the semiconductor block and one or more further electrodes that are arranged to generate an electric field within the semiconductor block for driving charge carriers of the first polarity generated therein due to incident radiation towards the at least one collector electrode; a radiation entrance window for receiving the incident radiation, the radiation entrance window arranged to cover at least portion of a back surface of the semiconductor block that is opposite to its front surface; and an arrangement of one or more layers having a net charge of the first polarity and arranged to substantially cover at least one side surface of the semiconductor block that connects said front surface to said back surface to induce an electric field for passivating the at least one side surface of the semiconductor block so as to reduce leakage currents arising therein.

The novel features which are considered as characteristic of the invention are set forth in particular in the appended claims. The invention itself, however, both as to its construction and its method of operation, together with additional objects and advantages thereof, will be best understood from the following description of specific embodiments when read in connection with the accompanying drawings.

The verbs "to comprise" and "to include" are used in this document as open limitations that neither exclude nor require the existence of also un-recited features. The features recited in dependent claims are mutually freely combinable unless otherwise explicitly stated. Furthermore, it is to be understood that the use of "a" or "an", i.e. a singular form, throughout this document does not exclude a plurality.

### BRIEF DESCRIPTION OF DRAWINGS

The embodiments of the invention are illustrated by way of example, and not by way of limitation, in the figures of the accompanying drawings, where:
Figure 1A schematically illustrates a SDD known in the art according to an example;
Figure 1B schematically illustrates a half of a symmetrical cross-section of a SDD known in the art according to an example;
Figure 2 schematically illustrates a half of a symmetrical cross-section of a SDD according to an example not covered by the claimed invention;
Figure 3 schematically illustrates a half of a symmetrical cross-section of a SDD according to an embodiment of the invention;
Figure 4 schematically illustrates a half of a symmetrical cross-section of a SDD according to an embodiment of the invention;
Figures 5A, 5B, 5C, 5D, 5E, 5F and 5G schematically illustrate examples of different electrode arrangements for an SDD;
Figures 6A, 6B and 6C schematically illustrate a half of a symmetrical cross-section of a PIN diode according to respective examples; and
Figures 7A, 7B and 7C schematically illustrates a half of a symmetrical cross-section of a pixel or strip detector according to respective examples.

### DETAILED DESCRIPTION

Before proceeding to description of examples of advantageous aspects of a SDD according to the present disclosure, some further aspects of the SDD 100 known in the art are described with references to Figure 1B, which schematically illustrates a half of a symmetrical cross-section of the SDD 100. The illustration of Figure 1B shows the collector electrode 103, the field electrodes 102 and the guard electrodes 104 described in the foregoing, each embedded to the front surface of the semiconductor block 101. The illustration of Figure 1B further depicts guard rings 104' and an entrance window electrode 106' embedded on the back surface of the semiconductor block 101, the respective outer electrodes 105 and 105' embedded on the front surface and on the back surface of the semiconductor block 101, the radiation entrance window 106, and the passivation layer 107 arranged to cover the front surface of the semiconductor block 101 and arranged to cover those parts of the back surface of the semiconductor block 101 that are not covered by the entrance window 106.

According to an example, the semiconductor block 101 may consist of a suitable n type semiconductor material, e.g. silicon, cut to a desired shape and size to serve as a 'body' of the SDD 100. Unless explicitly stated otherwise, the following examples describe structure and characteristics of the SDD 100 by assuming the semiconductor block 101 of n type polarity, where the majority charge carriers comprise particles of negative polarity (i.e. n type polarity). The field electrodes 102, the entrance window electrode 106' and the guard rings 104, 104' may comprise respective p⁺ doped regions of the semiconductor block 101, whereas the collector electrode 103 and the outer electrodes 105, 105' may comprise respective n⁺ doped regions of the semiconductor block 101. Hence, in this example the signal charges including electrons generated in the semiconductor block 101 due to incident radiation are driven by the electric field generated by the field electrodes 102 and the window electrode 106' to the collection electrode 103. Consequently, the collection electrode 103 may be referred to as an anode and the outer electrodes 105, 105' may be referred to as respective outer anodes. Herein, the p⁺ doping and/or the n⁺ doping may be provided, for example, via ion implantation.

Along the lines described in the foregoing, each of the radiation entrance window 106 and the passivation layer 107 may comprise, for example, a silicon dioxide (SiO₂) layer grown on the front and back surfaces of the semiconductor block 101 using a thermal oxidation process known in the art. While the passivation layer 107 may or may not be charged upon its manufacturing, ionizing radiation received at the SDD 100 in the course of its operation result in a permanent positive charge in the passivation layer 107. When provided with a suitable negative potential, the entrance window electrode 106' (together with the radiation entrance window 106) create an electric field that drives electrons generated in the semiconductor block 101 due to incident radiation towards the collector electrode 103.

Figure 1B further illustrates conductive contacts R₁, R_{X,b}, R_{X,f}, R_{A,c}, R_{A,b} and R_{A,f}, that enable making respective electrical connections to elements of the SDD 100. In this regard, the conductive contact R₁ serves to provide an electrical connection to the innermost one of the field electrodes 102 and the conductive contact R_{X,f} serves to provide an electrical connection to the outermost one of the field electrodes 102. Adjacent ones of the field electrodes 102 may be electrically coupled to each other via respective resistors (not shown in the illustration of Figure 1B), which may be implemented inside the semiconductor block 101 or outside the semiconductor block 101. Hence, the conductive contacts R₁ and R_{X,f} may be applied to bias the field electrodes 102 to respective negative electric potentials such that the magnitude of the electric potential (and hence a difference to the electric potential of the collector electrode 103) increases from the innermost one of the field electrodes 102 towards the outermost one of the field electrodes 102, thereby generating the electric field that drives the electrons generated in the semiconductor block 101 due to incident radiation towards the collector electrode 103. This may be accomplished, for example, by coupling the conductive contacts R₁ and R_{X,f}, respectively, to a negative potential of a small magnitude (e.g. to -15 Volts) and to a negative potential of a high magnitude (e.g. to -100 Volts).

The conductive contact R_{X,b} serves to provide an electrical connection to the entrance window electrode 106' and hence it may be applied to bias the entrance window electrode 106' to a desired electric potential, which may be the same as applied for the outermost one of the field electrodes 102. The conductive contact R_{A,c} serves to provide an electrical connection to the collector electrode 103 and hence enables obtaining the measurement signal from the SDD 100. The conductive contacts R_{A,f} and R_{A,b} serve to provide respective electrical connections to the outer electrodes 105 and 105' to enable biasing the outer electrodes 105, 105' in order to apply the guard rings 104, 104' to create an electric field that passivates the portion of the semiconductor block 101 that spatially coincides with the guard electrodes 104, 104' (e.g. the non-depleted volume, the non-active volume or the dead volume). In this regard, each of the conductive contacts R_{A,b} and R_{A,f} may be coupled to a negative potential of a small magnitude (e.g. to a ground potential).

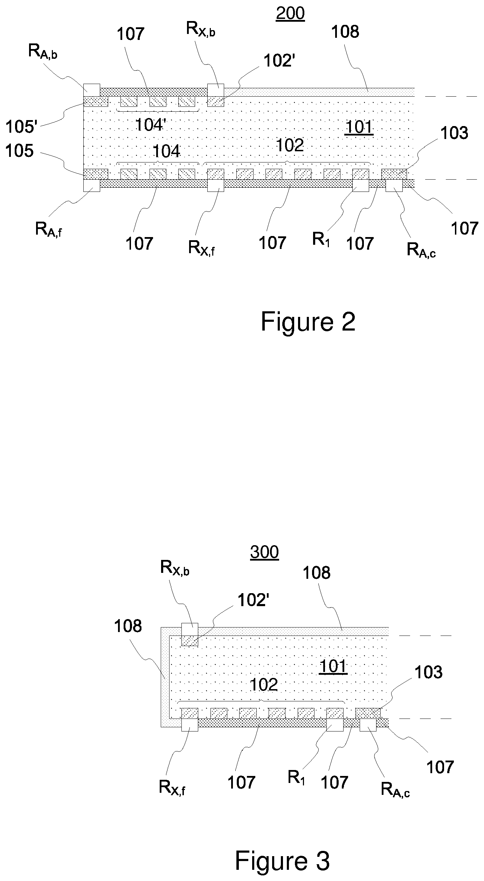

Figure 2 schematically illustrates a half of a symmetrical cross-section of a SDD 200 according to an example. The SDD 200 comprises the collector electrode 103, the field electrodes 102, the guard electrodes 104, 104', and the passivation layer 107, each embedded to the semiconductor block 101 as described in the foregoing with references to the SDD 100. Moreover, the SDD 200 comprises a back side field electrode 102', which may be embedded on the back surface of the semiconductor block 101 e.g. as a respective p⁺ doped region of the semiconductor block 101. Yet further, an arrangement of one or more layers 108 may be arranged to cover an area on the back surface of the semiconductor block 101 that spatially coincides the area on the front surface of the semiconductor block 101 provided with the field electrodes 102 (e.g. the depleted volume or the active volume), where the arrangement of one or more layers 108 may have a negative net charge and it may serve as a radiation entrance window for receiving the incident radiation. In this regard, the arrangement of one or more layers 108 may be, alternatively, referred to as a stack of one or more layers or as a layer stack. Along the lines described in the foregoing for the SDD 100, also in the SDD 200 the passivation layer 107 may be arranged to cover the front surface of the semiconductor block 101 and arranged to cover those parts of the back surface of the semiconductor block 101 that are not covered by the arrangement of one or more layers 108. The field electrodes 102, 102', the collector electrode 103 and the guard electrodes 104, 104' may be considered as an electrode arrangement of the SDD 200.

The negative net charge of the arrangement of one or more layers 108 covering the back surface of the semiconductor block 101 may arise from a negatively charged dielectric layer included in the arrangement of one or more layers 108. Such a dielectric layer may have a thickness in a range of a few tens of nanometers (nm), e.g. in the range from 10 to 100 nm. As an example, such a negatively charged dielectric layer may be grown by using a low-temperature technique such as atomic layer deposition (ALD). An advantage of the ALD (and similar techniques) is that it allows for controlling the thickness of the layer (or film) at one atomic layer precision, thereby enabling provision of a layer that has a desired thickness that is uniform throughout the area it serves to cover. Another advantage arising from usage of the ALD is that the resulting dielectric layer may be made inherently negatively charged. According to an example, the arrangement of the one or more layers 108 may include only (e.g. consist of) the negatively charged dielectric layer, whereas in another example the arrangement of one or more layers 108 may comprise another layer arranged between the negatively charged dielectric layer and the semiconductor block 101 in order to enhance the effect of the negatively charged dielectric layer. Such a layer may be referred to as an interim layer, and it may comprise, for example, a silicon oxide (SiO) layer and/or it may have a thickness in a range of approximately 1 to 100 nm, e.g. 20 nm.

According to an example, the negatively charged dielectric layer may comprise an oxide layer grown using the ALD (or a corresponding technique), e.g. a layer consisting of aluminum oxide (Al₂O₃), whereas other examples of oxide materials that are or can be made negatively charged to serve as the negatively charged dielectric layer include lanthanum oxide (La₂O₃), hafnium dioxide (HfO₂), titanium oxide (TiOₓ) and tantalum pentoxide (Ta₂O₅). In a further example, the negatively charged dielectric layer may comprise an ALD-grown aluminum nitride (Al₃N) layer, whereas in a yet further example a technique different from the ALD may be applied to provide the negatively charged dielectric layer, such as an amorphous boron layer, which may be deposited via application of a chemical vapor deposition (CVD) technique known in the art.

Hence, the arrangement of the one or more layers 108 serving as the radiation entrance window on the back surface of the semiconductor block 101 made of n type semiconductor material results in forming a (positively charged) inversion region in the (negatively charged) semiconductor block 101 immediately adjacent to the back surface of the semiconductor block 101, which forms a p-n junction together with the (negatively charged) remainder of the semiconductor block 101 and which is known as an induced junction. Consequently, the arrangement of the one or more layers 108 including the negatively charged dielectric layer or film arranged on the back surface of the n type semiconductor block 101 may be referred to as an induced junction radiation window. An advantage arising from such an induced junction radiation window is that the electric field induced in the semiconductor block 101 volume near the back surface thereof due to the p-n junction serves to repel electrons generated therein by incident radiation, thereby driving these electrons away from the back surface (where they could be lost due to recombinations) to allow them to drift towards the collector electrode 103 on the opposite side of the semiconductor block 101 and, consequently, contribute towards improved detection performance.

Figure 2 further illustrates the conductive contacts R₁, R_{X,b}, R_{X,f}, R_{A,c}, R_{A,b} and R_{A,f}, that enable making respective electrical connections to elements of the SDD 200. In this regard, the conductive contacts R₁, R_{X,f}, R_{A,c}, R_{A,b} and R_{A,f} serve the same purpose as described in the foregoing for the SDD 100, whereas the conductive contact R_{X,b} serves to provide an electrical connection to the back side field electrode 102' and hence it may be applied to bias the back side field electrode 102' to a desired electric potential, which may be the same as applied for the outermost one of the field electrodes 102.

Figure 3 schematically illustrates a half of a symmetrical cross-section of a SDD 300 according to an example. The SDD 300 comprises some of the components shown in Figure 2 for the SDD 200 and described above, i.e. the collector electrode 103 and the field electrodes 101 embedded on the front surface of the semiconductor block 101 as well as the passivation layer 107 arranged on the front surface of the semiconductor block 101. On the other hand, the guard rings 104, 104' and the outer electrodes 105, 105' that are present in the SDD 200 are not included in the SDD 300 and, consequently, the electrode arrangement of the SDD 300 comprises the field electrodes 102, 102' and the collector electrode 103. In the SDD 300, the arrangement of one or more layers 108 substantially covers the back side of the semiconductor block 101 in its entirety. Moreover, in the SDD 300 the arrangement of one or more layers 108 does not only substantially cover the back surface of the semiconductor block 101 but also extends to substantially cover side surface(s) of the semiconductor block 101 and may further extend to cover a portion of the front surface of the semiconductor block 101, e.g. from the edge of the semiconductor block 101 to the location of the outermost one of the field electrodes 102 (as illustrated in Figure 3). The SDD 300 may further comprise the conductive contacts R₁, R_{X,b}, R_{X,f} and R_{A,c} described in context of the SDD 200 that enable making respective electrical connections to elements of the SDD 300 in a manner described in the foregoing for the SDDs 100 and/or 200, whereas due to omission of the guard rings 104, 104' the conductive contacts R_{A,b}, R_{A,f} are likewise omitted from the SDD 300.

Like in the SDD 200, also in the SDD 300 the arrangement of the one or more layers 108 may serve as the radiation entrance window, which in case of the SDD 300 extends to substantially cover also the side surface(s) of the semiconductor block 101 and possibly further extends to cover a portion of the front surface of the semiconductor block 101. Herein, the aspect of the arrangement of one or more layers 108 substantially covering (also) the side surface(s) of the semiconductor block 101 means that the one or more layers either cover the side surface(s) in their entirety or leave on minor portion(s) of the side surface(s) uncovered, thereby causing the induced junction effect described in the foregoing also in the volume of the semiconductor block 101 close to the side surface(s) thereof.

When comparing the SDD 300 to the SDD 100 and SDD 200, due to extending the arrangement of one or more layers 108 to also substantially cover the side surface(s) of the semiconductor block 101, the SDD 300 enables dispensing with the guard rings 104 and the associated outer electrodes 105, 105': the arrangement of one or more layers 108 that extends also on a side surface of the semiconductor block 101 results in forming a (positively charged) inversion region within the (negatively charged) semiconductor block 101 also immediately adjacent to the side surface thereof, thereby creating an electric field that serves to passivate the volume of the semiconductor block 101 near the side surface and, consequently, serves to reduce or even completely eliminate leakage currents that might otherwise arise therein. Consequently, the arrangement of one or more layers 108 extending also to the side surface(s) of the semiconductor block 101 allows for using a larger portion of the surfaces of the semiconductor block 101 in relation to its overall size for receiving incident radiation and/or enables reducing the size of the SDD 300 without compromising the detection performance, while it also allows for accounting for incident radiation directed towards the side surface(s) of the semiconductor block 101.

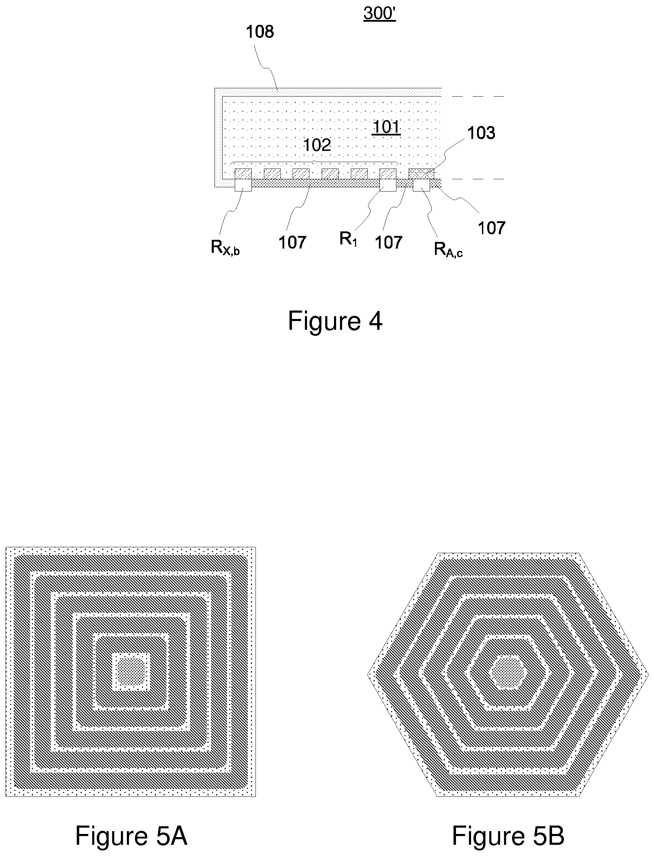

Figure 4 schematically illustrates a half of a symmetrical cross-section of a SDD 300', which is a variation of the SDD 300. In particular, the SDD 300' is similar to the SDD 300 apart from exclusion of the back side field electrode 102' and the respective conductive contact R_{X,b}. Hence, in the SDD 300' the electrode arrangement comprises the field electrodes 102 and the collector electrode 103. Due to the passive volume created close to the side surface(s) of the semiconductor block 101 via the arrangement of the one or more layers 108 extending also to substantially cover the side surface(s) of the semiconductor block 101 typically serves as a sufficient protection against leakage currents arising therefrom. Consequently, in the SDD 300' all elements embedded in the semiconductor block 101 (e.g. the collector electrode 103 and the field electrodes 102) are arranged on the front surface thereof and the electrical connections to elements of the SDD 300' are likewise made via the front surface of the semiconductor block 101. This is advantageous in terms of rendering the manufacturing process of the SDD 300' easier (in comparison to the SDDs 100, 200, 300) as well as in terms of enabling a straightforward manner of making the electrical connections to the SDD 300' upon installing the SDD 300' to a radiation detection assembly and/or to a radiation detector apparatus making use of the SDD 300'.

The examples pertaining to the structure and characteristics of the SDDs 200, 300, 300' described in the foregoing assume usage of the semiconductor block 101 of n type polarity. In other examples, the semiconductor block 101 may consist of a suitable semiconductor material (such as silicon) of p type polarity, where the majority charge carriers comprise particles of positive polarity (i.e. p type polarity).

In such examples the field electrodes 102 and the back side field electrode 102' (if included) may comprise respective n⁺ doped regions of the semiconductor block 101, whereas the collector electrode 103 and the outer electrodes 105, 105' (if included) may comprise respective p⁺ doped regions of the semiconductor block 101. Hence, in this example the signal charges include radiation-generated holes, which are driven by the electric field generated by the field electrodes 102 to the collection electrode 103. Consequently, the collection electrode 103 may be referred to as a cathode and the outer electrodes 105, 105' may be referred to as respective outer cathodes. As described in the foregoing, also in these examples the p⁺ doping and/or the n⁺ doping may be provided e.g. via ion implantation.

In the examples where the semiconductor block 101 has the p type polarity, the biasing voltages applied to the field electrodes 102 have an increasing positive magnitude from the innermost one of the field electrodes 102 to the outermost one of the field electrodes 102. Moreover, the arrangement of one or more layers 108 may have a positive net charge via inclusion of a positively charged dielectric layer, thereby serving as the radiation entrance window 108 that has a positive net charge. The positive net charge of the of the arrangement of one or more layers 108 may cause an induced junction in the semiconductor block 101 made of p type semiconductor material via forming a (negatively charged) inversion region in the (positively charged) semiconductor block 101 that results in a n-p junction together with the (positively) charged remainder of the semiconductor block 101. Examples of materials that are applicable for serving as the positively charged dielectric layer of the arrangement of one or more layers 108 include silicon dioxide (SiO₂), silicon nitride (SiNₓ), lanthanum oxide (La₂O₃), zirconium dioxide (ZrO₂) and phosphorus oxide - aluminum oxide stacks (PO_{X} / Al₂O₃). In the examples where the semiconductor block 101 has the p type polarity, the passivation layer 107 may comprise a negatively charged layer, e.g. one comprising or consisting of aluminum oxide (Al₂O₃).

The examples in the foregoing, at least implicitly, assume the semiconductor block 101 as a substantially flat entity with substantially planar front and back surfaces that are connected by one or more side surfaces (depending on the shape of the front and back surfaces). Hence, as non-limiting illustrative examples in this regard, the semiconductor block 101 may have a single side surface that connects substantially circular (planar) front and back surfaces or the semiconductor block 101 may have six side surfaces that connect substantially hexagonal (planar) front and back surfaces. In other examples, the back surface may be substantially non-planar. In various examples in this regard the back surface may have, for example, a convex (e.g. hemispherical) or pyramidical shape in order to more effectively capture incident radiation arriving from various directions. In such an arrangement, in an example, the non-planar back surface of the semiconductor block 101 may directly connect to the front surface without any side surface(s) therebetween, whereas in another example there may be one or more side surfaces connecting the non-planar back surface of the semiconductor block 101 to its front surface. In further examples, a non-planar back surface may have a concave shape or it may comprise black silicon, where a micro-structure of the silicon surface is not strictly planar but rather consists of adjacent 'needles' made of single-crystal silicon. In the latter example, e.g. in case of the SDDs 300, 300' the black silicon may further extend to cover the side(s) of the semiconductor block 101.

In the following discussion concerning the overall shape of the semiconductor block 101 applied as the 'body' of the SDD 200, 300, 300' and hence the shape of its front surface, the description simply refers to electrodes 102, 104 that may be provided on the front surface of the semiconductor block 101, whereas the electrodes 102', 104' possible provided on the back surface of the semiconductor block 101 may be assumed to have a shape similar to that of the front side electrodes 102, 104. In case of the SDD 200 this reference concerns both the field electrodes 102 and the guard electrodes 104, whereas in case of the SDDs 300, 300' this reference concerns the field electrodes 102 only. In an example, the SDD 200, 300, 300' described in the foregoing may be provided as one where the semiconductor block 101 has a circular shape with annular electrodes 102, 104 arranged on its front surface. In other examples, the shape of the semiconductor block 101 may be different from a circular one and/or the field electrodes 102 (and the guard electrodes 104, if applicable) may have a shape different from the annular one. Hence, the arrangement of the concentric annular electrodes 102, 104 generalizes into a respective arrangement of substantially nested electrodes 102, 104 of any shape that substantially surround the collector electrode 103 arranged within the innermost one of the field electrodes 102.

Non-limiting examples of various shapes for the semiconductor block 101 and arrangements of the electrodes 102, 104 on the front surface thereof are schematically illustrated in Figures 5A to 5E. Cutting the semiconductor into a desired shape and size may be carried out using a suitable technique known in the art, such as diamond blade sawing, ultrasonic cutting, laser cutting, reactive ion-etching (RIE), isotropic or non-isotropic wet etching or any combination thereof.

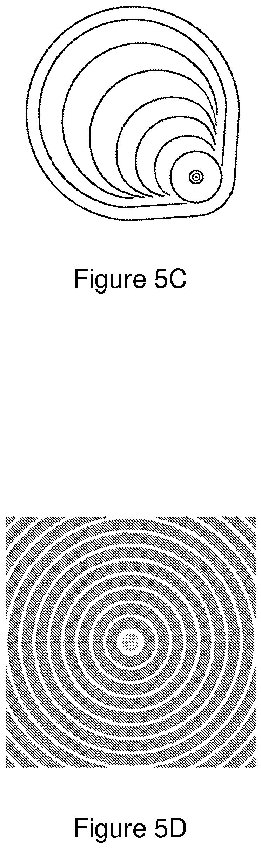

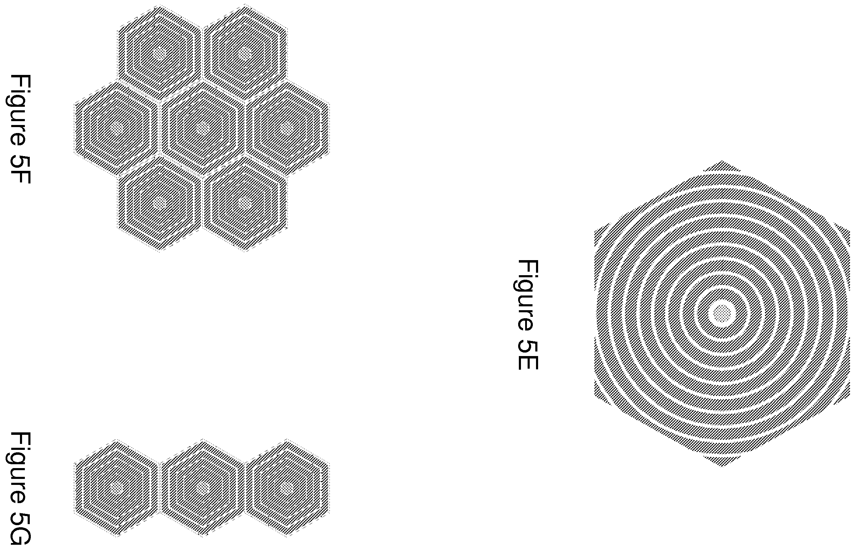

As examples of a non-circular and/or non-annular SDD design, the SDD 200, 300, 300' may comprise a semiconductor block 101 that has a rectangular (e.g. Figure 5A), a hexagonal (e.g. Figure 5B), a droplet-like (e.g. Figure 5C) or even an arbitrary shape with concentric electrodes 102, 104 having respective shapes that follow the shape of the outline of the semiconductor block 101 embedded on the front surface thereof. In a further example, the shape of the electrodes 102, 104 does not follow the shape of the outline of the semiconductor block 101. As non-limiting examples in this regard, the semiconductor block 101 may have a rectangular, a hexagonal or another non-circular shape with annular or substantially annular electrodes 102, 104 embedded on the front surface thereof, or electrodes 102, 104 having a rectangular, hexagonal or another non-annular shape may be embedded on the front surface of a circular semiconductor block 101. In such designs, at least some of the outermost electrodes 102, 104 may be non-continuous ones such that they are formed by two or more sections of a corresponding conceptual shape or a respective size (e.g. by two or more sections of a conceptual annulus of a corresponding diameter) to an extent it coincides with the area of the semiconductor block 101. Examples of such designs are shown in respective examples of Figures 5D and 5E In further examples, the semiconductor block 101 may be provided with a plurality of collector electrodes 103, each provided with a respective set of nested electrodes 102, 104 that substantially surround the respective one of the plurality of collector electrodes 103 arranged within the innermost one of the respective set of field electrodes 102, as shown in respective examples of Figures 5F and 5G.

The SDDs 200, 300, 300' described in the foregoing each involve an arrangement where the arrangement of one or more layers 108 covers at least the back surface of the semiconductor block 101 substantially in its entirety: in the SDD 200 the arrangement of one or more layers 108 cover the back surface to an extent it spatially coincides with the filed electrodes on the opposite surface of the semiconductor block 101 (i.e. the active or depleted volume), whereas in the SDDs 300, 300' the arrangement of one or more layers cover the back surface of the semiconductor block 101 substantially in its entirety while further substantially covering at least one side surface of the semiconductor block 101. In a further example, the arrangement of one or more layers 108 may be applied to substantially cover the at least one side surface of the semiconductor block 101 while leaving the back surface of the semiconductor block substantially uncovered or covering only a portion of the back surface at and/or close edges thereof. In such an arrangement the remainder of the back surface of the semiconductor block may be covered by a radiation window of the type described in the foregoing for the SDD 100. Also in this example the induced junction arising from the arrangement of one or more layers 108 on the side surface(s) of the semiconductor block 101 serves as protection against leakage currents and hence renders the guard electrodes 104 unnecessary also in this example.

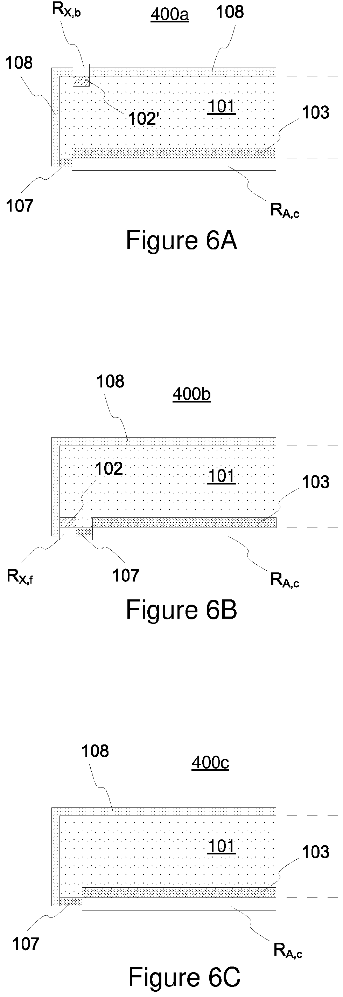

Even though the examples provided in the foregoing use a SDD as an example of a semiconductor radiation detector, the arrangement of one or more layers 108 is likewise applicable for serving as a coating of semiconductor radiation detectors of other types in order to improve their radiation detection characteristics in relation to their physical size. As an example in this regard, Figure 6A schematically illustrates a half of a symmetrical cross-section of a PIN diode 400a according to an example. In the example of Figure 6A, the electrode arrangement of the PIN diode 400 comprises the collector electrode 103 embedded on the front surface of the semiconductor block 101 and the back side field electrode 102' embedded on the back surface of the semiconductor block 101, whereas the conductive contact R_{A,c} allows for making an electrical connection to the collector electrode 103 and the conductive contact R_{X,b} allows for making an electrical connection to the back side field electrode 102'. The back side field electrode 102' may be applied to create the depleted volume within the semiconductor block 101. The example of Figure 6A further shows the arrangement of one or more layers 108 covering the back surface and the side surface(s) of the semiconductor block 101 apart from the conductive contact R_{X,b}, whereas the passivation layer 107 covers the front surface of the semiconductor block 101 to an extent it is not covered by the conductive contact R_{A,c}.

As described in the foregoing e.g. for the SDDs 300, 300', also in the PIN diode 400a, in one example, the semiconductor block 101 may be made of n type semiconductor material while the arrangement of one or more layers 108 may have a negative net charge, whereas in another example the semiconductor block 101 may be made of p type semiconductor material while the arrangement of one or more layers 108 may have a positive net charge, the arrangement of one or more layers 108 thereby serving as an induced junction radiation window that generates an electric field within the semiconductor block 101 for driving charge carriers generated therein due to the incident radiation towards the collector electrode 103 and for reducing (or completely eliminating) leakage currents via the side surface(s) of the semiconductor block 101.

Figure 6B schematically illustrates a half of a symmetrical cross-section of a PIN diode 400b according to another example. The PIN diode 400b is similar to the PIN diode 400a described above apart from omission of the back side field electrode 102' and the conductive contact R_{X,b} that allows for making the electrical connection thereto, the arrangement of one or more layers 108 thereby covering the back surface and the side surface(s) of the semiconductor block 101 substantially in their entirety. Instead, the PIN diode 400b comprises a single (front side) field electrode 102 embedded on the front surface of the semiconductor block 101 and the conductive contact R_{X,f} that allows for making an electrical connection to the front side field electrode 102, thereby facilitating creation of the depleted volume within the semiconductor block 101. In the PIN diode 400b, the passivation layer 107 covers the front surface of the semiconductor block 101 to an extent it is not covered by the conductive contacts R_{A,c} and R_{X,f}. In the PIN diode 400b all electrodes and their respective conductive contacts are provided on the front surface of the semiconductor block 101, which may be advantageous both in terms of rendering the manufacturing process easier and in terms of enabling a straightforward manner of making the electrical connections to the PIN diode 400b.

Figure 6C schematically illustrates a half of a symmetrical cross-section of a PIN diode 400c according to an example, which is similar to the PIN diode 400b described above apart from omission of the field electrode 102 and the respective conductive contact R_{X,f}. In the PIN diode 400c, the passivation layer 107 covers the front surface of the semiconductor block 101 to an extent it is not covered by the conductive contact R_{A,c}. A design according to this example may be advantageous in a scenario where the semiconductor block 101 is relatively thin: in such a scenario the electric field generated by the arrangement of one or more layers 108 may be sufficient in creating the depleted volume within the semiconductor block 101, thereby rendering the field electrode 102 and the conductive contact R_{X,f} for making electrical connection thereto unnecessary and, consequently, further simplifying the manufacturing process and connectivity of the PIN diode 400c.

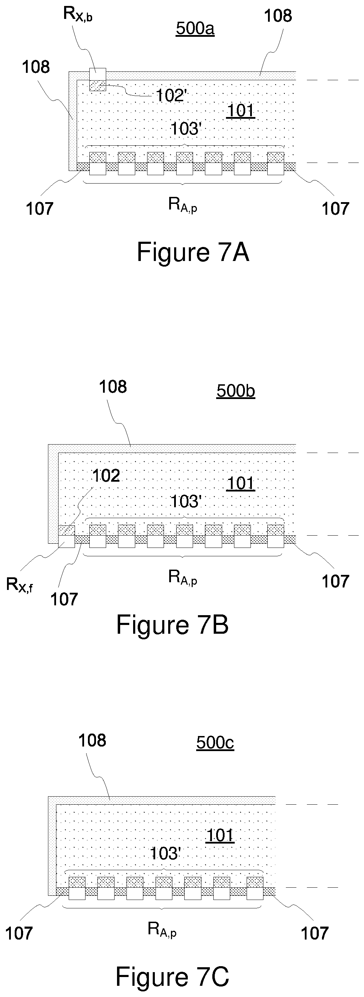

As another example of semiconductor radiation detectors of other type, Figure 7A schematically illustrates a half of a symmetrical cross-section of a pixel detector 500a according to an example. The pixel detector 500a may also be referred to as a strip detector. In the example of Figure 7A, the electrode arrangement of the pixel detector 500a comprises a set of collector electrodes 103' embedded on the front surface of the semiconductor block 101 and the back side field electrode 102' embedded on the back surface of the semiconductor block 101, whereas respective conductive contacts R_{A,p} allow for making electrical connections to the collector electrodes 103' while the conductive contact R_{X,b} allows for making an electrical connection to the back side field electrode 102'. The back side field electrode 102' may be applied to create the depleted volume within the semiconductor block 101. The example of Figure 7A further shows the arrangement of one or more layers 108 covering the back surface and the side surface(s) of the semiconductor block 101 apart from the location of the conductive contact R_{X,b}, whereas the passivation layer 107 covers the front surface of the semiconductor block 101 to an extent it is not covered by the conductive contacts R_{A,p}. (e.g. also between the conductive contacts R_{A,p})

As described in the foregoing e.g. for the SDDs 300, 300', also in the pixel detector 500a, in one example, the semiconductor block 101 may be made of n type semiconductor material while the arrangement of one or more layers 108 may have a negative net charge, whereas in another example the semiconductor block 101 may be made of p type semiconductor material while the arrangement of one or more layers 108 may have a positive net charge, the arrangement of one or more layers 108 thereby serving as an induced junction radiation window that generates an electric field within the semiconductor block 101 for driving charge carriers generated therein due to the incident radiation towards the collector electrodes 103' and for reducing (or completely eliminating) leakage currents via the side surface(s) of the semiconductor block 101.

Figure 7B schematically illustrates a half of a symmetrical cross-section of a pixel detector 500b according to another example. The pixel detector 500b is similar to the pixel detector 500a described above apart from omission of the back side field electrode 102' and the conductive contact R_{X,b} that allows for making the electrical connection thereto, the arrangement of one or more layers 108 thereby covering the back surface and the side surface(s) of the semiconductor block 101 substantially in their entirety. Instead, the pixel detector 500b comprises a single (front side) field electrode 102 embedded on the front surface of the semiconductor block 101 and the conductive contact R_{X,f} that allows for making an electrical connection to the front side field electrode 102, thereby facilitating creation of the depleted volume within the semiconductor block 101. In the pixel detector 500b, the passivation layer 107 covers the front surface of the semiconductor block 101 to an extent it is not covered by the conductive contacts R_{A,c} and R_{X,f}. In the pixel detector 500b all electrodes and their respective conductive contacts are provided on the front surface of the semiconductor block 101, which may be advantageous both in terms of rendering the manufacturing process easier and in terms of enabling a straightforward manner of making the electrical connections to the pixel detector 500b.

Figure 7C schematically illustrates a half of a symmetrical cross-section of a pixel detector 500c according to an example, which is similar to the pixel detector 500b described above apart from omission of the field electrode 102 and the respective conductive contact R_{X,f}. In the pixel detector 500c, the passivation layer 107 covers the front surface of the semiconductor block 101 to an extent it is not covered by the conductive contact R_{A,c}. A design according to this example may be advantageous in a scenario where the semiconductor block 101 is relatively thin: in such a scenario the electric field generated by the arrangement of one or more layers 108 may be sufficient in creating the depleted volume within the semiconductor block 101, thereby rendering the field electrode 102 and the conductive contact R_{X,f} for making electrical connection thereto unnecessary and, consequently, further simplifying the manufacturing process and connectivity of the pixel detector 500c.

At least some features of the semiconductor radiation detectors 200, 300, 300', 400a, 400b, 400c, 500a, 500b, 500c described in the foregoing may be used in combinations other than the combinations explicitly described. Although functions may have been described with reference to certain features, those functions may be performable by other features whether described or not. Although features have been described with reference to certain embodiments, those features may also be present in other embodiments whether explicitly described or not.

## Claims

1. A semiconductor radiation detector (300, 300', 400a, 400b, 400c, 500a, 500b, 500c), comprising:
a semiconductor block (101) of a first conductivity type and comprising majority charge carriers of a first polarity;
an electrode arrangement embedded on one or more surfaces of the semiconductor block (101), the electrode arrangement comprising at least one collector electrode (103, 103') embedded on a front surface of the semiconductor block (101) and one or more further electrodes (102, 102') that are arranged to generate an electric field within the semiconductor block (101) for driving charge carriers of the first polarity generated therein due to incident radiation towards the at least one collector electrode (103, 103');
a radiation entrance window for receiving the incident radiation, the radiation entrance window arranged to cover at least portion of a back surface of the semiconductor block (101) that is opposite to its front surface; and
an arrangement of one or more layers (108) having a net charge of the first polarity,
**characterized in that** said arrangement of one or more layers (108) is arranged to substantially cover at least one side surface of the semiconductor block (101) that connects said front surface to said back surface to induce an electric field for passivating said at least one side surface of the semiconductor block (101) so as to reduce leakage currents arising therein.

2. A semiconductor radiation detector (300, 300', 400a, 400b, 400c, 500a, 500b, 500c) according to claim 1, wherein said arrangement of one or more layers (108) extends to cover said at least a portion of the back surface of the semiconductor block (101) to provide said radiation entrance window, said arrangement of one or more layers (108) thereby inducing an electric field within the semiconductor block (101) for driving the charge carriers of the first polarity generated therein due to the incident radiation from the back surface towards the at least one collector electrode (103, 103').

3. A semiconductor radiation detector (300, 300', 400a, 400b, 400c, 500a, 500b, 500c) according to claim 1, wherein said arrangement of one or more layers (108) includes a dielectric layer having a charge of the first polarity.

4. A semiconductor radiation detector (300, 300', 400a, 400b, 400c, 500a, 500b, 500c) according to any of claim 1 to 3, wherein the first polarity is n type.

5. A semiconductor radiation detector (300, 300', 400a, 400b, 400c, 500a, 500b, 500c) according to claim 4, wherein said dielectric layer comprises a layer made of one of the following:
aluminum oxide, Al₂O₃,
lanthanum oxide, La₂O₃,
hafnium oxide, HfO₂,
aluminum nitride, AlN,
titanium oxide, TiO_{X},
tantalum pentoxide, Ta₂O₅,
amorphous boron.

6. A semiconductor radiation detector (300, 300', 400a, 400b, 400c, 500a, 500b, 500c) according to any of claims 1 to 3, wherein the first polarity is p type.

7. A semiconductor radiation detector (300, 300', 400a, 400b, 400c, 500a, 500b, 500c) according to claim 6, wherein said dielectric layer comprises one of the following:
zirconium dioxide, ZrO₂,
silicon dioxide, SiO₂,
lanthanum oxide, La₂O₃,
silicon nitride, SiNₓ,
a phosphorus oxide - aluminum oxide stack, PO_{X} / A₂O₃.

8. A semiconductor radiation detector (300, 300', 400a, 400b, 400c, 500a, 500b, 500c) according to any of claims 1 to 7, wherein the back surface of the semiconductor block (101) is substantially planar.

9. A semiconductor radiation detector (300, 300', 400a, 400b, 400c, 500a, 500b, 500c) according to any of claims 1 to 7, wherein the back surface of the semiconductor block (101) is substantially non-planar.

10. A semiconductor radiation detector (300, 300', 400a, 400b, 400c, 500a, 500b, 500c) according to claim 9, wherein the back surface of the semiconductor block (101) has a convex, concave or pyramidical shape.

11. A semiconductor radiation detector (300, 300', 400a, 400b, 400c, 500a, 500b, 500c) according to any of claims 1 to 10, wherein at least one of the following applies:
the back surface of the semiconductor block (101) comprises black silicon,
the at least one side surface of the semiconductor block (101) comprises black silicon.

12. A semiconductor radiation detector (300, 300', 400a, 400b, 400c, 500a, 500b, 500c) according to any of claims 1 to 11, further comprising a passivation layer (107) arranged to cover at least some of those portions of the front and back surfaces of the semiconductor block (101) that are not covered by the arrangement of one or more layers (108).

13. A semiconductor radiation detector according to any of claims 1 to 12, comprising a silicon drift detector (300, 300'), wherein the electrode arrangement comprises:
a collector electrode (103) and a set of nested field electrodes (102) embedded on the front surface of the semiconductor block (101) such that they surround the collector electrode (103), wherein the field electrodes (102) are arranged to generate, when biased to respective electric potentials of increasing magnitude from the innermost one towards the outermost one of the field electrodes (102), an electric field within the semiconductor block (101) for driving charge carriers of the first polarity generated therein due to incident radiation towards the collector electrode (103).

## Patentansprüche

1. Halbleiterstrahlungsdetektor (300, 300', 400a, 400b, 400c, 500a, 500b, 500c), Folgendes umfassend:
einen Halbleiterblock (101) eines ersten Leitfähigkeitstyps, der Majoritätsladungsträger einer ersten Polarität umfasst;
eine Elektrodenanordnung, die auf einer oder mehreren Oberflächen des Halbleiterblocks (101) eingebettet ist, wobei die Elektrodenanordnung mindestens eine Kollektorelektrode (103, 103'), die auf einer Vorderfläche des Halbleiterblocks (101) eingebettet ist, und eine oder mehrere weitere Elektroden (102, 102') umfasst, die eingerichtet sind, um ein elektrisches Feld innerhalb des Halbleiterblocks (101) zu erzeugen, um Ladungsträger der ersten Polarität, die aufgrund einfallender Strahlung darin erzeugt werden, in Richtung der mindestens einen Kollektorelektrode (103, 103') zu treiben;
ein Strahlungseintrittsfenster zum Empfangen der einfallenden Strahlung, wobei das Strahlungseintrittsfenster angeordnet ist, um mindestens einen Abschnitt einer Rückfläche des Halbleiterblocks (101) zu bedecken, die seiner Vorderfläche gegenüberliegt; und
eine Anordnung einer oder mehrerer Schichten (108) mit einer Nettoladung der ersten Polarität,
**dadurch gekennzeichnet, dass** die Anordnung einer oder mehrerer Schichten (108) eingerichtet ist, um im Wesentlichen mindestens eine Seitenfläche des Halbleiterblocks (101) zu bedecken, welche die Vorderfläche mit der Rückfläche verbindet, um ein elektrisches Feld zum Passivieren der mindestens einen Seitenfläche des Halbleiterblocks (101) zu induzieren, um darin entstehende Leckströme zu reduzieren.

2. Halbleiterstrahlungsdetektor (300, 300', 400a, 400b, 400c, 500a, 500b, 500c) nach Anspruch 1, wobei sich die Anordnung einer oder mehrerer Schichten (108) ausdehnt, um mindestens einen Abschnitt der Rückfläche des Halbleiterblocks (101) zu bedecken, um das Strahlungseintrittsfenster bereitzustellen, wobei die Anordnung einer oder mehrerer Schichten (108) dadurch ein elektrisches Feld innerhalb des Halbleiterblocks (101) induziert, um die Ladungsträger der ersten Polarität, die aufgrund der von der Rückfläche einfallenden Strahlung darin erzeugt werden, in Richtung der mindestens einen Kollektorelektrode (103, 103') zu treiben.

3. Halbleiterstrahlungsdetektor (300, 300', 400a, 400b, 400c, 500a, 500b, 500c) nach Anspruch 1, wobei die Anordnung einer oder mehrerer Schichten (108) eine dielektrische Schicht mit einer Ladung der ersten Polarität umfasst.

4. Halbleiterstrahlungsdetektor (300, 300', 400a, 400b, 400c, 500a, 500b, 500c) nach einem der Ansprüche 1 bis 3, wobei die erste Polarität N-leitend ist.

5. Halbleiterstrahlungsdetektor (300, 300', 400a, 400b, 400c, 500a, 500b, 500c) nach Anspruch 4, wobei die dielektrische Schicht eine Schicht umfasst, die aus einem des Folgenden angefertigt ist:
Aluminiumoxid, Al₂O₃,
Lanthanoxid, La₂O₃,
Hafniumoxid, HfO₂,
Aluminiumnitrid, AlN,
Titanoxid, TiO_{X},
Tantalpentoxid, Ta₂O₅,
amorphes Bor.

6. Halbleiterstrahlungsdetektor (300, 300', 400a, 400b, 400c, 500a, 500b, 500c) nach einem der Ansprüche 1 bis 3, wobei die erste Polarität P-leitend ist.

7. Halbleiterstrahlungsdetektor (300, 300', 400a, 400b, 400c, 500a, 500b, 500c) nach Anspruch 6, wobei die dielektrische Schicht eines des Folgenden umfasst:
Zirkoniumdioxid, ZrO₂,
Siliziumdioxid, SiO₂,
Lanthanoxid, La₂O₃,
Siliziumnitrid, SiN_{X},
einen Phosphoroxid-Aluminiumoxid-Stapel, PO_{X}/Al₂O₃.

8. Halbleiterstrahlungsdetektor (300, 300', 400a, 400b, 400c, 500a, 500b, 500c) nach einem der Ansprüche 1 bis 7, wobei die Rückfläche des Halbleiterblocks (101) im Wesentlichen planar ist.

9. Halbleiterstrahlungsdetektor (300, 300', 400a, 400b, 400c, 500a, 500b, 500c) nach einem der Ansprüche 1 bis 7, wobei die Rückfläche des Halbleiterblocks (101) im Wesentlichen nicht planar ist.

10. Halbleiterstrahlungsdetektor (300, 300', 400a, 400b, 400c, 500a, 500b, 500c) nach Anspruch 9, wobei die Rückfläche des Halbleiterblocks (101) eine konvexe, konkave oder pyramidenförmige Gestalt aufweist.

11. Halbleiterstrahlungsdetektor (300, 300', 400a, 400b, 400c, 500a, 500b, 500c) nach einem der Ansprüche 1 bis 10, wobei mindestens eines des Folgenden zutrifft:
die Rückfläche des Halbleiterblocks (101) umfasst schwarzes Silizium,
die mindestens eine Seitenfläche des Halbleiterblocks (101) umfasst schwarzes Silizium.

12. Halbleiterstrahlungsdetektor (300, 300', 400a, 400b, 400c, 500a, 500b, 500c) nach einem der Ansprüche 1 bis 11, weiterhin umfassend eine Passivierungsschicht (107), die eingerichtet ist, um mindestens einige jener Abschnitte der Vorder- und Rückfläche des Halbleiterblocks (101) zu bedecken, die nicht durch die Anordnung einer oder mehrerer Schichten (108) bedeckt sind.

13. Halbleiterstrahlungsdetektor nach einem der Ansprüche 1 bis 12, umfassend einen Siliziumdriftdetektor (300, 300'), wobei die Elektrodenanordnung Folgendes umfasst:
eine Kollektorelektrode (103) und einen Satz verschachtelter Feldelektroden (102), die derartig auf der Vorderfläche des Halbleiterblocks (101) eingebettet sind, dass sie die Kollektorelektrode (103) umgeben, wobei die Feldelektroden (102) eingerichtet sind, um, wenn sie auf jeweilige elektrische Potenziale zunehmender Größe von der innersten in Richtung der äußersten der Feldelektroden (102) vorgespannt sind, ein elektrisches Feld innerhalb des Halbleiterblocks (101) zu erzeugen, um Ladungsträger der ersten Polarität, die aufgrund einfallender Strahlung darin erzeugt werden, in Richtung der Kollektorelektrode (103) zu treiben.

## Revendications

1. Détecteur de rayonnement à semi-conducteurs (300, 300', 400a, 400b, 400c, 500a, 500b, 500c), comprenant :
un bloc semi-conducteur (101) d'un premier type de conductivité et comprenant des porteurs de charge majoritaires d'une première polarité ;
un agencement d'électrodes intégré sur une ou plusieurs surfaces du bloc semi-conducteur (101), l'agencement d'électrodes comprenant au moins une électrode collectrice (103, 103') intégrée sur une surface avant du bloc semi-conducteur (101) et une ou plusieurs électrodes supplémentaires (102, 102') qui sont agencées pour générer un champ électrique à l'intérieur du bloc semi-conducteur (101) afin **d'entraîner** des porteurs de charge de la première polarité générés au sein de celui-ci sous l'effet d'un rayonnement incident vers l'au moins une électrode collectrice (103, 103') ;
une fenêtre d'entrée de rayonnement destinée à recevoir le rayonnement incident, la fenêtre **d'entrée** de rayonnement étant agencée pour recouvrir au moins une partie **d'une** surface arrière du bloc semi-conducteur (101) qui se situe à l'opposé de sa surface avant ; et un agencement d'une ou plusieurs couches (108) ayant une charge nette de la première polarité,
**caractérisé en ce que** ledit agencement d'une ou plusieurs couches (108) est agencé pour recouvrir en grande partie au moins une surface latérale du bloc semi-conducteur (101) qui relie ladite surface avant à ladite surface arrière afin **d'induire** un champ électrique en vue de passiver ladite au moins une surface latérale du bloc semi-conducteur (101) de manière à réduire les courants de fuite qui y apparaissent.

2. Détecteur de rayonnement à semi-conducteurs (300, 300', 400a, 400b, 400c, 500a, 500b, 500c) selon la revendication **1,** dans lequel ledit agencement d'une ou plusieurs couches (108) s'étend pour recouvrir ladite au moins une partie de la surface arrière du bloc semi-conducteur (101) afin de fournir ladite fenêtre d'entrée de rayonnement, ledit agencement d'une ou de plusieurs couches (108) induisant ainsi un champ électrique à l'intérieur du bloc semi-conducteur (101) afin d'entraîner les porteurs de charge de la première polarité générés au sein de celui-ci sous **l'effet** du rayonnement incident depuis la surface arrière vers l'au moins une électrode collectrice (103, 103').

3. Détecteur de rayonnement à semi-conducteurs (300, 300', 400a, 400b, 400c, 500a, 500b, 500c) selon la revendication **1,** dans lequel ledit agencement d'une ou plusieurs couches (108) comporte une couche diélectrique ayant une charge de la première polarité.

4. Détecteur de rayonnement à semi-conducteurs (300, 300', 400a, 400b, 400c, 500a, 500b, 500c) selon l'une quelconque des revendications 1 à 3, dans lequel la première polarité est du type **n.**

5. Détecteur de rayonnement à semi-conducteurs (300, 300', 400a, 400b, 400c, 500a, 500b, 500c) selon la revendication **4,** dans lequel ladite couche diélectrique comprend une couche constituée d'un des composés suivants :
oxyde d'aluminium, Al₂O₃,
oxyde de lanthane, La₂O₃,
oxyde d'hafnium, HfO₂,
nitrure d'aluminium, AlN,
oxyde de titane, TiOₓ,
pentoxyde de tantale, Ta₂O₅,
bore amorphe.

6. Détecteur de rayonnement à semi-conducteurs (300, 300', 400a, 400b, 400c, 500a, 500b, 500c) selon l'une quelconque des revendications 1 à 3, dans lequel la première polarité est du type p.

7. Détecteur de rayonnement à semi-conducteurs (300, 300', 400a, 400b, 400c, 500a, 500b, 500c) selon la revendication 6, dans lequel ladite couche diélectrique comprend un des composés suivants :
dioxyde de zirconium, ZrO₂,
dioxyde de silicium, SiO₂,
oxyde de lanthane, La₂O₃,
nitrure de silicium, SiN_{X},
empilement oxyde de phosphore - oxyde d'aluminium PO_{X}/Al₂O₃.

8. Détecteur de rayonnement à semi-conducteurs (300, 300', 400a, 400b, 400c, 500a, 500b, 500c) selon l'une quelconque des revendications 1 à 7, dans lequel la surface arrière du bloc semi-conducteur (101) est sensiblement plane.

9. Détecteur de rayonnement à semi-conducteurs (300, 300', 400a, 400b, 400c, 500a, 500b, 500c) selon l'une quelconque des revendications 1 à 7, dans lequel la surface arrière du bloc semi-conducteur (101) est sensiblement non plane.

10. Détecteur de rayonnement à semi-conducteurs (300, 300', 400a, 400b, 400c, 500a, 500b, 500c) selon la revendication 9, dans lequel la surface arrière du bloc semi-conducteur (101) a une forme convexe, concave ou pyramidale.

11. Détecteur de rayonnement à semi-conducteurs (300, 300', 400a, 400b, 400c, 500a, 500b, 500c) selon l'une quelconque des revendications 1 à 10, dans lequel au moins une des situations suivantes s'applique :
la surface arrière du bloc semi-conducteur (101) comprend du silicium noir,
l'au moins une surface latérale du bloc semi-conducteur (101) comprend du silicium noir.

12. Détecteur de rayonnement à semi-conducteurs (300, 300', 400a, 400b, 400c, 500a, 500b, 500c) selon l'une quelconque des revendications 1 à 11, comprenant en outre une couche de passivation (107) agencée pour recouvrir au moins certaines des parties des surfaces avant et arrière du bloc semi-conducteur (101) qui ne sont pas recouvertes par l'agencement d'une ou plusieurs couches (108).

13. Détecteur de rayonnement à semi-conducteurs selon l'une quelconque des revendications 1 à 12, comprenant un détecteur de dérive au silicium (300, 300'), l'agencement d'électrodes comprenant :
une électrode collectrice (103) et un ensemble d'électrodes de champ imbriquées (102) intégrées sur la surface avant du bloc semi-conducteur (101) de telle sorte qu'elles entourent l'électrode collectrice (103), les électrodes de champ (102) étant agencées pour générer, lorsqu'elles sont polarisées à des potentiels électriques respectifs d'amplitude croissante en partant de l'électrode la plus à l'intérieur vers l'électrode la plus à l'extérieur des électrodes de champ (102), un champ électrique à l'intérieur du bloc semi-conducteur (101) destiné à entraîner des porteurs de charge de la première polarité générés au sein de celui-ci sous l'effet d'un rayonnement incident vers l'électrode collectrice (103).
